# EUROPEAN PATENT SPECIFICATION

(11) **EP 4 284 127 B1**
(45) Date of publication and mention of the grant of the patent: **05.08.2026**
(21) Application number: 22756455.6
(22) Date of filing: 15.02.2022
(51) Int. Cl.: H05K 5/00, H05K 5/03, H04M 1/02, H04M 1/18, H05K 5/06, G06F 1/16

(54) **ELECTRONIC DEVICE COMPRISING GLASS HAVING DIFFERENTIAL EDGE SHAPE**
ELEKTRONISCHE VORRICHTUNG MIT GLAS MIT UNTERSCHIEDLICHER RANDFORM
DISPOSITIF ÉLECTRONIQUE COMPRENANT DU VERRE AYANT UNE FORME DE BORD DIFFÉRENTIELLE

(30) Priority: 16.02.2021 KR 20210020746
(43) Date of publication of application: 29.11.2023
(73) Proprietor: Samsung Electronics Co., Ltd., Suwon-si, Gyeonggi-do 16677 (KR)
(72) Inventor: BAE, Jaehyun, Suwon-si Gyeonggi-do 16677 (KR); MOON, Youngmin, Suwon-si Gyeonggi-do 16677 (KR); LEE, Changsu, Suwon-si Gyeonggi-do 16677 (KR); CHOI, Hyunsuk, Suwon-si Gyeonggi-do 16677 (KR)
(74) Representative: Nederlandsch Octrooibureau
(86) International application number: PCT/KR2022/002197
(87) International publication number: WO 2022/177257

(56) References cited:
- CN-A- 108 975 718
- KR-A- 20180 018 941
- KR-A- 20180 040 498
- KR-A- 20200 070 904
- KR-A- 20200 108 754
- KR-A- 20210 013 606
- KR-B1- 102 133 261
- US-A1- 2017 374 749
- US-A1- 2020 292 731
- US-B2- 10 509 439
- US-B2- 9 446 566

## Description

### [Technical Field]

Various embodiments disclosed herein relate to an electronic device including a flexible display.

### [Background Art]

As the demand for mobile communication increases and the degree of integration of electronic devices increases, portability of electronic devices such as mobile communication terminals may be improved, and convenience in using multimedia functions may be improved. For example, by replacing a traditional mechanical (button-type) keypad with a display in which a touch screen function is integrated, it is possible to downsize an electronic device while maintaining the function of the input device thereof. For example, by removing a mechanical keypad from an electronic device, it is possible to improve the portability of the electronic device. In another embodiment, when a display is expanded by the area in which a mechanical keypad is removed, an electronic device including a touch screen function may provide a larger screen compared to an electronic device including a mechanical keypad, even when the electronic device including the touch screen function has the same size and weight as the electronic device including the mechanical keypad.

In using a web surfing or multimedia function, it may be more convenient for a user to use an electronic device that outputs a large screen. A larger display may be mounted on an electronic device in order to output a large screen. However, in view of the portability of the electronic device, there may be restrictions in increasing the size of the display. In an embodiment, a display using an organic light-emitting diode or the like may make it possible to ensure portability of an electronic device while providing a larger screen. For example, a display using an organic light-emitting diode (or an electronic device equipped with the display) is capable of implementing a stable operation even if the display is made very thin so that the display can be mounted in an electronic device in a foldable, bendable, slidable, or rollable type. As described above, by mounting a display using an organic light-emitting diode in an electronic device in a foldable, slidable, or rollable type, it is possible to provide an electronic device that outputs a larger screen to a user.
US 2020/0292731 A1 discusses a flexible cover window, the cover window being a glass-based cover window for a flexible display and including: a folding part slimmed by corresponding to a folding area of the display, wherein a thickness of the cover window is 50 to 300 µm and a thickness of the folding part is 20 to 100 µm.
US 9,446,566 B2 discusses a laminate obtained by integrally laminating glass sheets on both surfaces of a resin sheet. The glass sheets have a thickness of 300 µm or less and end surfaces of the glass sheets are chamfered.
KR 102133261 B1 discusses a display including a panel module layer including an outer protective layer formed with at least a portion of an edge having a certain curvature, an opaque layer disposed at the edge of the outer protective layer, and a non-display area arranged under the opaque layer, and an electronic device including the same.
US 2017/0374749 A1 discusses a mobile terminal comprising a flexible display; a first body positioned at a rear of the flexible display, the first body connected to the flexible display; a second body positioned at the rear of the flexible display, the second body connected to the flexible display and spaced apart from the first body, the second body movable with respect to the first body; a hinge assembly positioned at the rear of the flexible display, the hinge assembly located between the first body and the second body, the hinge assembly connecting the first body and the second body; and a hinge cover positioned at a lateral side of the hinge assembly, the hinge cover between the first body and the second body, wherein the hinge cover has a thinner thickness toward a central portion of the hinge cover from both ends of the hinge cover in a direction from the hinge cover toward the hinge assembly.

### [Detailed Description of the Invention]

### [Technical Problem]

A window glass may be provided to protect the display from external physical/chemical shocks. The window glass may be laminated on one surface of the display and exposed outside the housing.

In a conventional electronic device such as a smartphone or a tablet PC, since the area of the screen output from the display is fixed, the size of the window glass exposed outside the housing is also fixed. Accordingly, in the conventional electronic device, there is no need to perform a separate processing process for the edge portions of the window glass. In addition, in the conventional electronic device, the edge portions of a window glass are typically fabricated to have a uniform thickness.

Unlike this, a display mounted on an electronic device in a foldable, slidable, or rollable type (hereinafter, referred to as a "flexible display") may have a variable screen output area, so the area of the window glass that is exposed outside the housing may also be variable. For example, in an electronic device including a foldable display, the areas of the display and the window glass exposed outside the housing may become smaller or larger by folding and unfolding operations of the electronic device. As another example, in an electronic device including a slidable display, the exposed areas of the display and the window glass exposed outside the housing may become smaller or larger by the sliding-in or sliding-out operation of the electronic device. In an electronic device including such a flexible display, in the window glass that has not undergone a separate processing process for the edge portions, there is a possibility that defects, such as fractures due to bumping during handling or crack propagation during bending, may occur due to cracks and etching marks present on the edge surfaces.

According to some embodiments, bending performance may be improved by processing the edge portions of the window glass to be thin. However, in this case, since the thickness of the window glass is thin, impact resistance may deteriorate. Conversely, when the edge portions are thickened to increase the impact resistance of the window glass, bending performance may deteriorate. As such, the bending performance and the impact resistance of the window glass are in a trade-off relationship with each other.

According to various embodiments of the disclosure, it is intended to provide an electronic device including a window glass in which defects such as fractures are prevented through machining of edge portions.

According to various embodiments of the disclosure, it is intended to provide an electronic device including a foldable, slidable, or rollable-type display and a window glass laminated on the display, wherein the window glass has high impact resistance and excellent bending performance.

### [Technical Solution]

According to a first aspect of the present invention, there is provided an electronic device as specified in claim 1. Exemplary embodiments are set out in dependent claims 2-14.

Various embodiments disclosed herein are capable of proving a window member mounted on a flexible electronic device. The window member includes a first portion having a first thickness, and a second portion extending from the first portion in a first direction such that at least a portion thereof has a thickness substantially equal to that of the first portion. The second portion corresponds to a bendable portion of the flexible electronic device, and includes an edge area in a second direction perpendicular to the first direction, the edge area having a second thickness smaller than the first thickness.

### [Advantageous Effects]

According to various embodiments of the disclosure, it is possible to provide an electronic device including foldable thin glass (FTG) as a window member.

According to various embodiments of the disclosure, it is possible to reduce the possibility of damage due to handling during a process by removing cracks present on the edges of the window member through a polishing process.

According to various embodiments of the disclosure, it is possible to improve bending performance by reducing the thickness of the bendable area of the window member.

According to various embodiments of the disclosure, the window member is able to have high impact resistance because the non-bendable portion has a relatively larger thickness compared to the bendable portion.

According to various embodiments of the disclosure, it is possible to overcome the trade-off relationship between bending performance and impact resistance of the window member by implementing a difference in edge shape between the bendable area and the non-bendable area.

### [Brief Description of Drawings]

FIG. 1 is a block diagram of an electronic device according to various embodiments of the disclosure in a network environment.
FIG. 2 is a view illustrating the state in which an electronic device according to various embodiments of the disclosure is unfolded.
FIG. 3 is a view illustrating the state in which the electronic device according to various embodiments is folded.
FIG. 4 is a perspective view illustrating an example of the fully unfolded state or the partially unfolded intermediate state of the electronic device according to various embodiments of the disclosure.
FIG. 5 is a view illustrating an electronic device according to various embodiments disclosed herein, in the state in which a portion of a flexible display is accommodated in a second structure.
FIG. 6 is a view illustrating the electronic device according to various embodiments disclosed herein, in the state in which most of the flexible display is exposed to the outside of the second structure.
FIG. 7 is a perspective view illustrating an electronic device according to various embodiments disclosed herein.
FIG. 8 is an exploded perspective view illustrating the electronic device according to various embodiments disclosed herein.
FIG. 9 is a block diagram illustrating an electronic device according to another embodiment disclosed herein.
FIG. 10A is a conceptual view illustrating deformation of a window member in a foldable electronic device according to various embodiments of the disclosure.
FIG 10B is a conceptual view illustrating curvatures of a first edge and a second edge of a window member in a foldable electronic device according to various embodiments of the disclosure.
FIG. 11 is a view illustrating a display mounted on a slidable electronic device according to various embodiments of the disclosure and a window member included in the display.
FIG. 12 is a cross-sectional view illustrating a window member according to various embodiments of the disclosure.
FIG. 13 is a cross-sectional view illustrating a second portion of a window member according to various embodiments of the disclosure.
FIG. 14 is a perspective view illustrating a window member mounted on a foldable electronic device according to various embodiments of the disclosure.
FIG. 15 is a cross-sectional view illustrating an impact resistance improving structure (e.g., an impact absorbing member) included in an electronic device according to various embodiments of the disclosure.
FIG. 16 is a cross-sectional view illustrating a waterproof member included in an electronic device according to various embodiments of the disclosure.

### [Mode for Carrying out the Invention]

Hereinafter, various embodiments of the disclosure may be described with reference to the accompanying drawings.

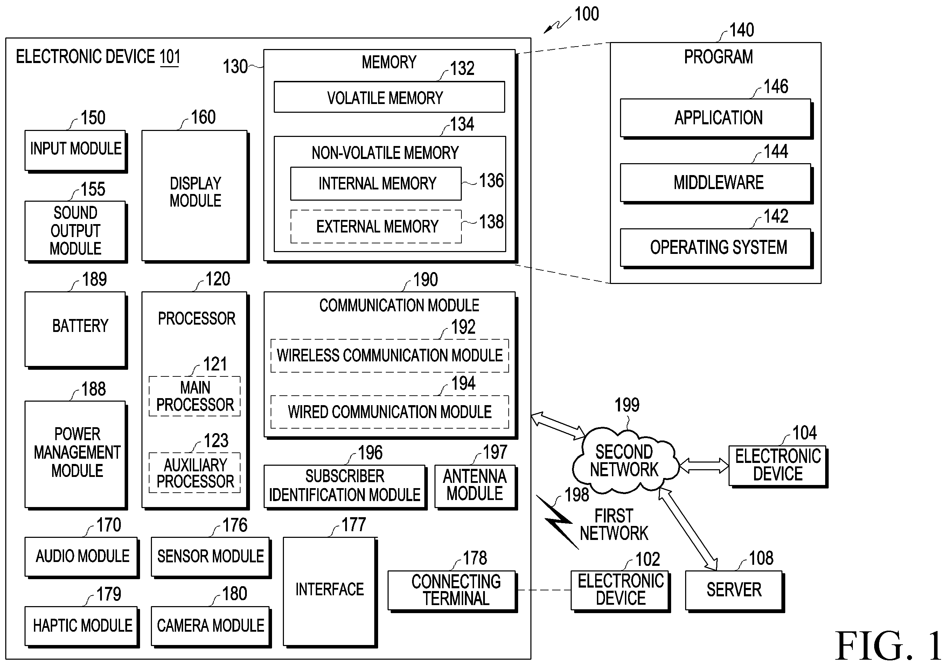

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

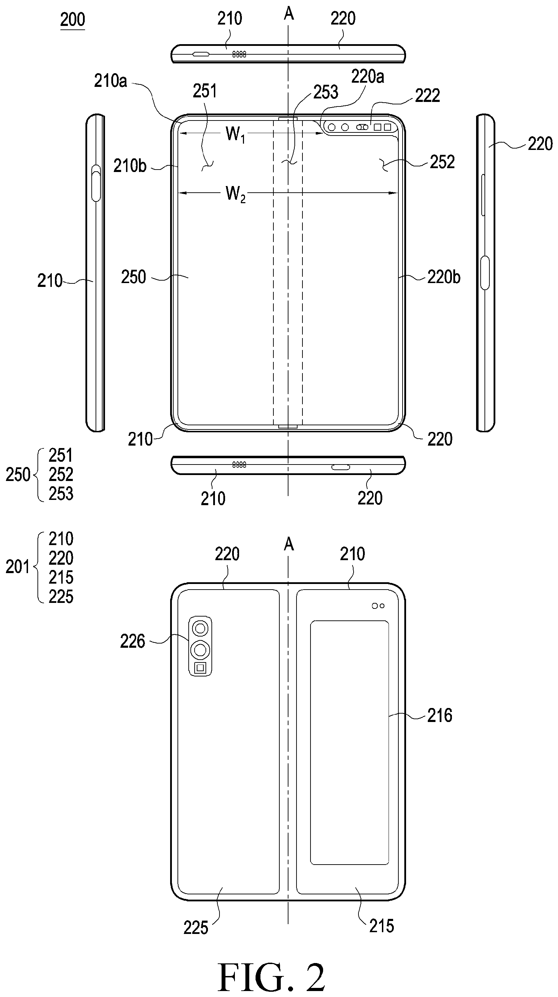

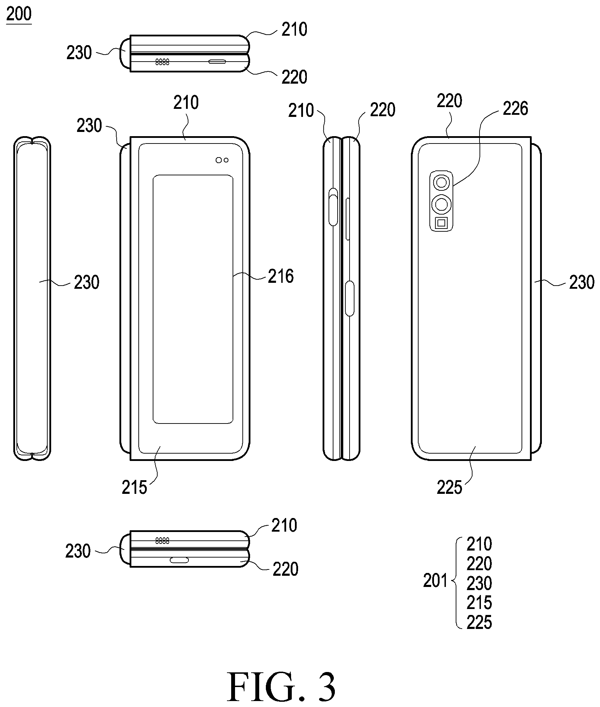

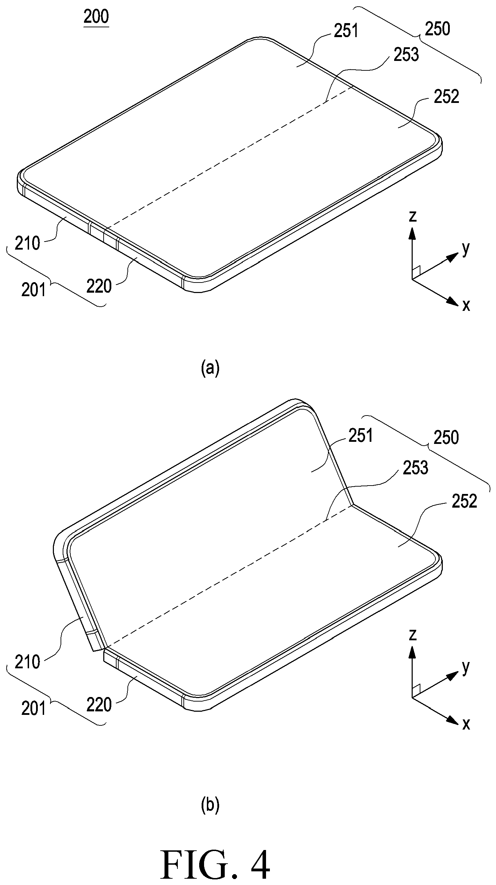

FIG. 2 is a view illustrating the unfolded state of an electronic device 200 according to various embodiments of the disclosure. FIG. 3 is a view illustrating the folded state of the electronic device 200 according to various embodiments of the disclosure. FIG. 4 is a perspective view illustrating an example of the fully unfolded state or the partially unfolded intermediate state of the electronic device 200 according to various embodiments of the disclosure.

The electronic device 200 of FIGS. 2 to 4 is an example of the electronic device 101 illustrated in FIG. 1, and may be a foldable or bendable electronic device.

In FIG. 4 and subsequent drawings, a spatial coordinate system defined by the X axis, the Y axis, and the Z axis orthogonal to each other is illustrated. Here, the X axis may represent a width direction of the electronic device, the Y axis may represent a length direction of the electronic device, and the Z axis may represent a height (or thickness) direction of the electronic device. In the following description, a "first direction" may mean a direction parallel to the Z axis.

Referring to FIGS. 2 and 3, in an embodiment, the electronic device 200 may include a foldable housing 201 and a flexible or foldable display 250 (hereinafter, simply referred to as a "display 250") (e.g., the display device 160 in FIG. 1) disposed in a space defined by the foldable housing 201. According to an embodiment, the surface on which the display 250 is disposed (or the surface on which the display 250 is visible from the outside of the electronic device 200) may be defined as the front surface of the electronic device 200. In addition, the surface opposite to the front surface may be defined as the rear surface of the electronic device 200. Furthermore, the surface surrounding the space between the front surface and the rear surface may be defined as the side surface of the electronic device 200.

According to various embodiments, the foldable housing 201 may include a first housing structure 210, a second housing structure 220 including a sensor area 222, a first rear surface cover 215, a second rear surface cover 225, and a hinge structure 230. Here, the hinge structure 230 may include a hinge cover which covers a foldable portion of the foldable housing 201. The foldable housing 201 of the electronic device 200 is not limited to the shape and assembly illustrated in FIGS. 2 and 3, but may be implemented by a combination and/or an assembly of different shapes or components. For example, in another embodiment, the first housing structure 210 and the first rear surface cover 215 may be configured integrally with each other, and the second housing structure 220 and the second rear surface cover 225 may be configured integrally with each other.

According to various embodiments, the first housing structure 210 is connected to the hinge structure 230, and may include a first surface oriented in a first direction and a second surface oriented in a second direction opposite the first direction. The second housing structure 220 is connected to the hinge structure 230, and may include a third surface oriented in a third direction and a fourth surface oriented in a fourth direction opposite the third direction. The second housing structure 220 is rotatable relative to the first housing structure 210 about the hinge structure 230. The electronic device 200 may be deformable to the folded state or the unfolded state.

According to an embodiment, in the fully folded state of the electronic device 200, the first surface may face the third surface, and in the fully unfolded state, the third direction may be the same as the first direction.

According to various embodiments, the first housing structure 210 and the second housing structure 220 may be disposed on opposite sides about the folding axis A and may have generally symmetrical shapes with respect to the folding axis A. As will be described later, the first housing structure 210 and the second housing structure 220 may form an angle or a distance therebetween, which may be variable depending on whether the electronic device 200 is in the unfolded state, in the folded state, or in the intermediate state in which the electronic device 101 is partially unfolded (or partially folded). According to an embodiment, unlike the first housing structure 210, the second housing structure 220 may further include the sensor area 222 in which various sensors are disposed, but the first housing structure 310 and the second housing structure 320 may have mutually symmetrical shapes in other areas.

According to various embodiments, as illustrated in FIG. 2, the first housing structure 210 and the second housing structure 220 may define a recess that accommodates the display 200 therein. According to an embodiment, due to the sensor area 222, the recess may have two or more different widths in a direction perpendicular to the folding axis A. According to an embodiment, the recess may have a first width w1 between a first portion 210a parallel to the folding axis A of the first housing structure 210 and a first portion 220a provided at the periphery of the sensor area 222 of the second housing structure 220. The recess may have a second width w2 defined by a second portion 210b of the first housing structure 210 and a second portion 220b of the second housing structure 220, which is parallel to the folding axis A while not corresponding to the sensor area 222. In this case, the second width w2 may be greater than the first width w1. According to an embodiment, the first portion 220a and the second portion 220b of the second housing structure 220 may have different distances from the folding axis A, respectively. The width of the recess is not limited to the illustrated example. In another embodiment, the recess may have multiple widths due to the shape of the sensor area 222 or the asymmetrical portions of the first housing structure 210 and the second housing structure 220. According to various embodiments, the sensor area 222 may be configured to have a predetermined area adjacent to one corner of the second housing structure 220. However, the arrangement, shape, and size of the sensor area 222 are not limited to those in the illustrated example. For example, in another embodiment, the sensor area 222 may be provided at another corner of the second housing structure 220 or in any area between the upper and lower end corners. In an embodiment, components embedded in the electronic device 200 to carry out various functions may be exposed on the front surface of the electronic device 200 through the sensor area 222 or through one or more openings provided in the sensor area 222. In various embodiments, the components may include various types of sensors. The sensors may include, for example, at least one of a front camera, a receiver, or a proximity sensor. According to various embodiments, the sensor area 222 in the second housing structure 220 may be omitted or may be provided at a position different from that illustrated in the drawings.

According to various embodiments, at least a portion of the first housing structure 210 and at least a portion of the second housing structure 220 may be made of a metal material or a non-metal material having the rigidity of a level selected to support the display 250. The at least a portion made of the metal material may provide a ground plane of the electronic device 200, and may be electrically connected to a ground line provided on a printed circuit board disposed inside the foldable housing 201.

According to various embodiments, the first rear surface cover 215 may be disposed on the rear surface of the electronic device 200 on one side of the folding axis A and may have, for example, a substantially rectangular periphery, which may be surrounded by the first housing structure 210. Similarly, the second rear surface cover 225 may be arranged on the other side of the folding axis A of the rear surface of the electronic device 200, and the periphery of the second rear surface cover 390 may be enclosed by the second housing structure 220.

According to various embodiments, the first rear surface cover 215 and the second rear surface cover 225 may have substantially symmetrical shapes about the folding axis A. However, the first rear surface cover 215 and the second rear surface cover 225 do not necessarily have mutually symmetrical shapes, and in another embodiment, the electronic device 200 may include a first rear surface cover 215 and a second rear surface cover 225 having various shapes. In another embodiment, the first rear surface cover 215 may be configured integrally with the first housing structure 210, and the second rear surface cover 225 may be configured integrally with the second housing structure 220.

According to various embodiments, the first rear surface cover 215, the second rear surface cover 225, the first housing structure 210, and the second housing structure 220 may define a space in which various components (e.g., a printed circuit board or a battery) of the electronic device 200 may be disposed. According to an embodiment, one or more components may be disposed or visually exposed on the rear surface of the electronic device 200. For example, at least a portion of a sub-display may be visually exposed through a first rear surface area 216 of the first rear surface cover 215. In another embodiment, one or more components or sensors may be visually exposed through a second rear surface area 226 of the second rear surface cover 225. In various embodiments, the sensors may include a proximity sensor and/or a rear camera.

According to various embodiments, a front camera, which is exposed on the front surface of the electronic device 200 through one or more openings provided in the sensor area 222 or a rear camera, which is exposed through the second rear surface area 226 of the second rear surface cover 225, may include one or more lenses, an image sensor, and/or an image signal processor. The flash may include, for example, a light-emitting diode or a xenon lamp. In some embodiments, two or more lenses (e.g., an infrared camera, a wide-angle lens, and a telephoto lens), and image sensors may be disposed on one surface of the electronic device 200.

Referring to FIG. 3, the hinge cover may be configured to cover internal components (e.g., the hinge structure 230) by being disposed between the first housing structure 210 and the second housing structure 220. According to an embodiment, the hinge structure 230 may be covered by a portion of the first housing structure 310 and a portion of the second housing structure 320, or may be exposed outside depending on the state of the electronic device 200 (the unfolded state, the intermediate state, or the folded state).

According to an embodiment, as illustrated in FIG. 2, when the electronic device 200 is in the unfolded state (e.g., the fully unfolded state), the hinge structure 230 may not be exposed by being covered by the first housing structure 210 and the second housing structure 220. As another example, as illustrated in FIG. 3, when the electronic device 200 is in the folded state (e.g., the fully folded state), the hinge case 230 may be exposed outside between the first housing structure 210 and the second housing structure 220. As another example, when the first housing structure 210 and the second housing structure 220 are in the intermediate state of being folded with a certain angle therebetween, the hinge structure 230 may be partially exposed outside between the first housing structure 210 and the second housing structure 220. However, in this case, the exposed area may be smaller than that in the fully folded state. In an embodiment, the hinge structure 230 may include a curved surface.

According to various embodiments, the display 250 may be disposed in a space defined by the foldable housing 201. For example, the display 250 may be seated in the recess defined by the foldable housing 201, and may be visible to the outside through the front surface of the electronic device 200. For example, the display 250 may constitute most of the front surface of the electronic device 200. Accordingly, the front surface of the electronic device 200 may include the display 250, and partial areas of the first housing structure 210 and the second housing structure 220, which are adjacent to the display 250. In addition, the rear surface of the electronic device 200 may include the first rear surface cover 215, a partial area of the first housing structure 210 adjacent to the first rear surface cover 215, the second rear surface cover 225, and a partial area of the second housing structure 220 adjacent to the second rear surface cover 225.

According to various embodiments, the display 250 may be a display at least a partial area of which is deformable into a flat surface or a curved surface. According to an embodiment, the display 250 may include a folding area 253, a first area 251 arranged on one side of the folding area 253 (e.g., the left side of the folding area 253 illustrated in FIG. 2), and a second area 252 arranged on the other side of the folding area 253 (e.g., the right side of the folding area 253 illustrated in FIG. 2).

However, the area division of the display 250 illustrated in FIG. 2 is exemplary, and the display 250 may be divided into multiple (e.g., four or more or two) areas depending on the structures or functions thereof. For example, in the embodiment illustrated in FIG. 2, the areas of the display 200 may be divided by the folding area 203 extending in parallel to the folding axis A, but in another embodiment, the display 200 may be divided with reference to another folding axis (e.g., a folding axis parallel to the width direction of the electronic device).

According to various embodiments of the disclosure, the display 250 may be coupled to or disposed adjacent to a touch panel equipped with a touch detection circuit and a pressure sensor capable of measuring the intensity (pressure) of a touch. For example, as an example of a touch panel, the display 250 may be coupled to or disposed adjacent to a touch panel that detects an electromagnetic resonance (EMR)-type stylus pen.

According to various embodiments, the first area 251 and the second area 252 may have generally symmetrical shapes about the folding area 253. However, unlike the first area 251, the second area 252 may include a notch cut due to the presence of the sensor area 222, but may have a shape symmetrical to the first area 251 in areas other than the sensor area. In other words, the first area 251 and the second area 252 may include portions having mutually symmetrical shapes and portions having mutually asymmetrical shapes.

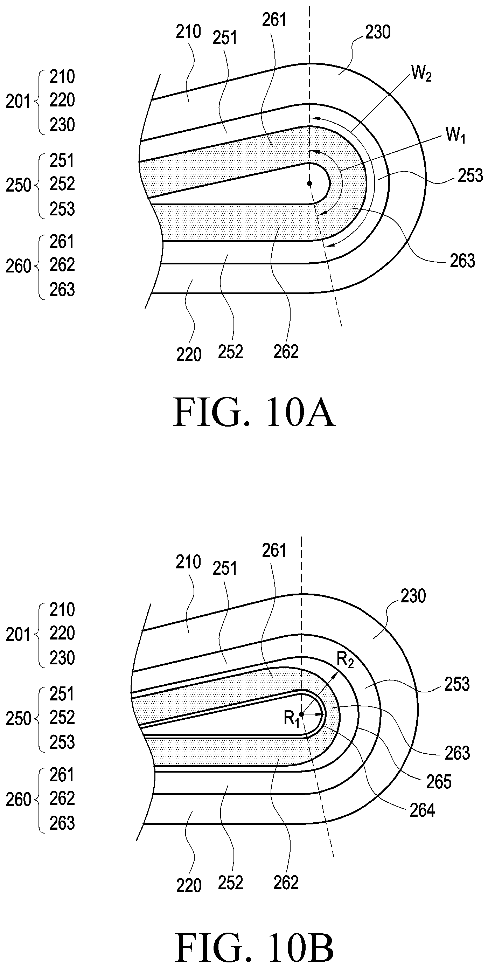

According to present invention, the edge thicknesses of the first area 251 and the second area 252 is different from that of the folding area 253. The edge thickness of the folding area 253 is smaller than those of the first area 251 and the second area 252. In terms of thickness, the first area 251 and the second area 252 have asymmetrical shapes when the first area 251 and the second area 252 are viewed in cross sections thereof. For example, the edge of the first area 251 may have a first radius of curvature, and the edge of the second area 252 may have a second radius of curvature different from the first radius of curvature. In another embodiment, in terms of thickness, the first area 251 and the second area 252 may have symmetrical shapes when the first area 251 and the second area 252 are viewed in cross sections thereof. These will be described in detail later with reference to the embodiments illustrated in the drawings in FIG. 10A and subsequent figures.

Hereinafter, the operations of the first housing structure 210 and the second housing structure 220 and respective areas of the display 250 according to the state of the electronic device 200 (e.g., the unfolded state, the folded state, or the intermediate state) will be described.

According to various embodiments, when the electronic device 200 is in the unfolded state (e.g., FIG. 2), the first housing structure 210 and the second housing structure 220 may be disposed to form an angle of 180 degrees therebetween and to be oriented in the same direction. The surface of the first area 251 and the surface of the second area 252 of the display 250 form 180 degrees from each other and may face the same direction (e.g., the front direction of the electronic device). The folding area 253 may form the same plane as the first area 251 and the second area 252.

According to various embodiments, when the electronic device 200 is in the folded state (e.g., FIG. 3), the first housing structure 210 and the second housing structure 220 may be disposed to face each other. The surface of the first area 251 and the surface of the second area 252 of the display 250 may face each other while forming a narrow angle (e.g., an angle between 0 degrees and 10 degrees) relative to each other. At least a portion of the folding area 253 may be provided as a curved surface having a predetermined curvature.

According to various embodiments, when the electronic device 200 is in the intermediate state, the first housing structure 210 and the second housing structure 220 may be disposed to form a certain angle relative to each other. The surface of the first area 251 and the surface of the second area 252 of the display 250 may form an angle greater than that in the folded state and smaller than that in the unfolded state. At least a portion of the folding area 253 may form a curved surface having a predetermined curvature, and the curvature in this case may be smaller than that in the folded state.

(a) of FIG. 4 may illustrate a fully unfolded state of the electronic device 200, and (b) of FIG. 4 may illustrate a partially unfolded intermediate state of the electronic device 200. As described above, the electronic device 200 may be deformed into the folded state or the unfolded state. According to an embodiment, the electronic device 200 may be foldable in two types, i.e. an "in-folding" type in which the front surface of the electronic device 200 is folded to form an acute angle when viewed in the folding axis direction (e.g., the axis A in FIG. 2) and an "out-folding" type in which the front surface of the electronic device 200 is folded to form an obtuse angle when viewed in the folding axis direction. For example, when the electronic device 200 is in the state of being folded in the in-folding state, the first surface of the first housing structure 210 to the third surface may face the third surface of the second housing structure 220, and when the electronic device 220 is in the state of being fully unfolded in the in-folding type, the first surface of the first housing structure 210 and the third surface of the second housing structure 220 may be oriented in the same direction (e.g., a direction parallel to the Z axis).

As another example, when the electronic device 200 is in the state of being folded in the out-folding type, the second surface of the first housing structure 210 may face the fourth surface of the second housing structure 220.

In addition, although not illustrated in the drawings, the electronic device 200 may include multiple hinge axes (e.g., two hinge axes parallel to each other including the axis A in FIG. 2 and another axis parallel to the axis A). In this case, the electronic device 200 may be folded in a "multi-folding" type in which the in-folding type and the out-folding type are combined.

The in-folding type may mean the type in which the display 250 is not exposed outside in the fully folded state. The out-folding type may mean the type in which the display 250 is exposed outside in the fully folded state. (b) of FIG. 4 illustrates a partially unfolded intermediate state in which the electronic device 200 is partially unfolded in the process of in-folding.

Hereinafter, for convenience, the electronic device 200 will be described focusing on the state in which the electronic device 200 is folded in the in-folding type, but it should be noted that this description is also applicable to the state in which the electronic device 200 is folded in the out-folding type.

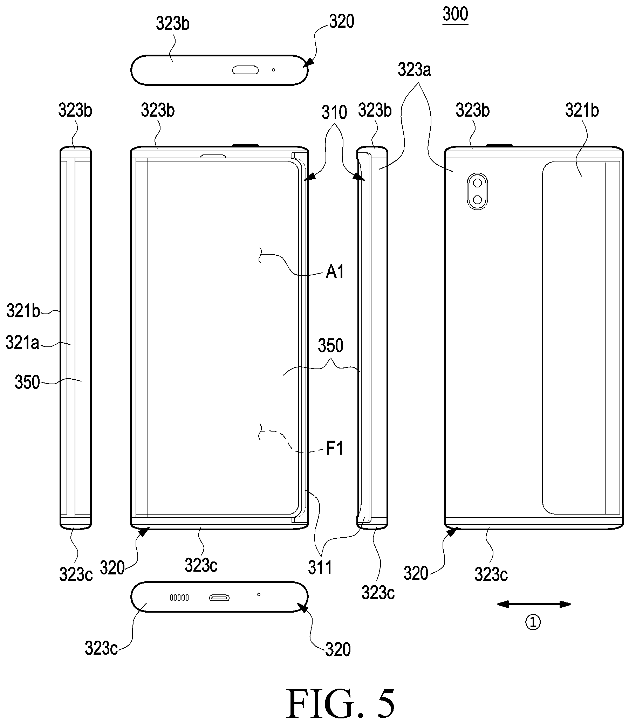

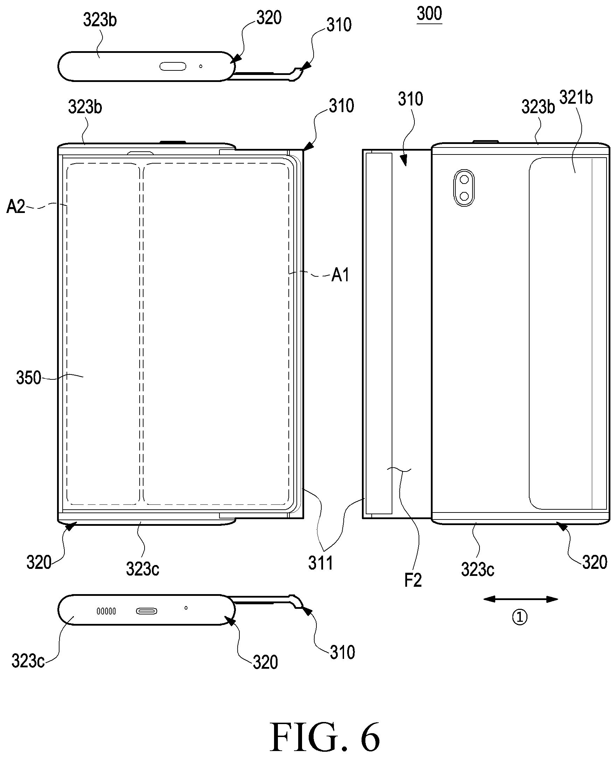

FIG. 5 is a view illustrating an electronic device 300 according to various embodiments disclosed herein in the state in which a portion of a flexible display 350 is accommodated in a second structure 320. FIG. 6 is a view illustrating the electronic device 300 according to various embodiments disclosed herein in the state in which most of the flexible display 350 is exposed outside the second structure 320.

The electronic device 300 of FIGS. 5 and 6 is another example of the electronic device 101 illustrated in FIG. 1 and may be a slidable electronic device.

The state illustrated in FIG. 5 may be defined as the state in which the first structure 310 is closed relative to the second structure 320, and the state illustrated in FIG. 6 may be defined as the state in which the first structure 310 is opened relative to the second structure 320. According to an embodiment, the "closed state" or the "opened state" may be defined as the state in which the electronic device is closed or the state in which the electronic device is opened. According to an embodiment, the closed state of the electronic device 300 may be defined as the state in which the width of the slidable housing 301 of the electronic device 300 is the minimum, and the opened state of the electronic device 300 may be defined as the state in which the width of the slidable housing 301 of the electronic device 200 is the maximum. According to another embodiment, the closed state of the electronic device 300 may be defined as the state in which the area of the portion of the display 350 exposed outside is minimized, and the opened state of the electronic device 300 may be defined as the state in which the area of the display 350 exposed outside is maximized.

Referring to FIGS. 5 and 6, the electronic device 300 may include a first structure 310 and a second structure 320 disposed to be movable on the first structure 310. In some embodiments, the electronic device 300 may be interpreted as having a structure in which the first structure 310 is disposed to be slidable on the second structure 320. According to an embodiment, the first structure 310 may be disposed to be reciprocal by a predetermined distance in the illustrated direction (e.g., the direction indicated by arrow ①) with respect to the second structure 320.

According to various embodiments, the first structure 310 may be referred to as, for example, a first housing structure, a slide unit, or a slide housing, and may be disposed to be reciprocal on the second structure 320. In an embodiment, the second structure 320 may be referred to as, for example, a second housing, a main unit, or a main housing, and may accommodate various electrical and electronic components such as a main circuit board or a battery. A portion (e.g., the first area A1) of the display 350 may be seated on the first structure 310. According to an embodiment, when the first structure 310 moves (e.g., slides) relative to the second structure 320, another portion (e.g., the second area A2) of the display 350 may be accommodated inside the second structure 320 (e.g., a slide-in operation) or exposed outside the second structure 320 (e.g., a slide-out operation). Here, a portion (e.g., the first area A1) of the display 350 may be a basic use area when the display 350 is in the slide-in state, and another portion (e.g., the second area A2) of the display 350 may be an expansion area in the slide-out state.

FIGS. 5 and 6 illustrate an embodiment in which the basic use area (e.g., the first area A1) of the display 350 in the slid-in state is seated on the first structure 310. In addition, according to the embodiment illustrated in FIG. 6, the basic use area (e.g., the first area A1) of the display 350 in the slide-out state is disposed on the right side in the direction in which is expanded, and the expansion area (e.g., the second area A2) is disposed on the left side of the display 350. However, the disclosure is not necessarily limited thereto. Unlike that illustrated in FIG. 6, the basic use area (e.g., the first area A1) of the display 350 in the slid-out state may be disposed on the left side, which is opposite to the direction in which the display 350 is expanded, and the expansion area (e.g., the second area A2) may be disposed on the right side of the display 350.

According to various embodiments, the first structure 310 may include a first plate 311 (e.g., a slide plate) and may include a first surface F1 including at least a portion of the first plate 311 and a second surface F2 facing away from the first surface F1. According to an embodiment, the second structure 320 may include a second plate 321a (e.g., a rear surface case), a first side wall 323a extending from the second plate 321a, a second side wall 323b extending from the first side wall 323a and the second plate 321a, a third side wall 323c extending from the first side wall 323a and the second plate 321a and parallel to the second side wall 323b, and/or a rear surface plate 321b (e.g., a rear window). In some embodiments, the second side wall 323b and the third side wall 323c may be perpendicular to the first side wall 323a. According to an embodiment, the second plate 321a, the first side wall 323a, the second side wall 323b, and the third side wall 323c may be opened on one side (e.g., the front surface) to accommodate (or surround) at least a portion of the first structure 310. For example, the first structure 310 is coupled to the second structure 320 in a state of being at least partially surrounded and may slide in a direction parallel to the first surface F1 or the second surface F2 (e.g., the direction indicated by arrow ①) while being guided by the second structure 320.

According to various embodiments, the second side wall 323b or the third side wall 323c may be omitted. According to an embodiment, the second plate 321a, the first side wall 323a, the second side wall 323b, and/or the third side wall 323c may be configured as separate structures and coupled or assembled to each other. The rear surface plate 321b may be coupled to surround at least a portion of the second plate 321a. In another embodiment, the rear surface plate 321b may be substantially integrated with the second plate 321a. According to an embodiment, the second plate 321a or the rear surface plate 321b may cover at least a portion of the flexible display 350. For example, the flexible display 350 may be at least partially accommodated inside the second structure 320, and the second plate 321a or the rear surface plate 321b may cover a portion of the flexible display 350 accommodated inside the second structure 320.

According to various embodiments, the first structure 310 is movable to the opened state or the closed state relative to the second structure 320 in a first direction (e.g., direction ①) parallel to the second plate 321a (e.g., the rear surface case) and the first side wall 323a, wherein the first structure 310 is located at a first distance from the first side wall 323a in the closed state and at a second distance, which is greater than the first distance, from the first side wall 323a in the opened state. In some embodiments, in the closed state, the first structure 310 may be located to surround a portion of the first side wall 323a.

According to various embodiments, unlike the above-described embodiments, the first sidewall 323a may move integrally with the first structure 310. The second structure 320 may include a fourth side wall (not illustrated) located opposite to the first side wall 323a, and may be applied in a form in which, in the state in which the fourth side wall (not illustrated) is fixed, the first side wall 323a moves away from the fourth side wall (not illustrated) simultaneously with the movement of the first structure 310. In addition, the expansion of the slidable housing according to the sliding movement of the first structure 310 may vary depending on embodiments.

According to various embodiments, the electronic device 300 may include a display 350, a key input device, a connector hole, an audio module, or a camera module. Although not illustrated, the electronic device 300 may further include an indicator (e.g., an LED device) or various sensor modules. Here, the display 350 may be coupled to or disposed adjacent to a touch detection circuit, a pressure sensor capable of measuring a touch intensity (pressure), and/or a digitizer configured to detect a magnetic field-type stylus pen.

According to various embodiments, the display 350 may include a first area A1 and a second area A2. In an embodiment, the first area A1 may extend substantially across at least a portion of the first plate 311 to be disposed on the first surface F1. The second area A2 may extend from the first area A1 and may be inserted or accommodated inside the second structure 320 (e.g., the main housing) or may be exposed outside the second structure 320 according to the sliding of the first structure 311. As will be described later, the second area A2 may be moved while substantially being guided by a guide member (e.g., a roller) mounted on the second structure 320 to be accommodated inside the second structure 320 or exposed outside the second structure 320. For example, while the first structure 310 slides, a portion of the second area A2 may be deformed into a curved shape at a position corresponding to the guide member. According to various embodiments, when viewed from above the first plate 311 (e.g., the slide plate), if the first structure 310 moves from the closed state to the opened state, the second area A2 may provide a substantially flat surface along with the first area A1 while being gradually exposed outside the second structure 320. In some embodiments, the second area A2 may be at least partially accommodated inside the second structure 320, and a portion of the second area A2 may also be exposed outside even in the state illustrated in FIG. 5 (e.g., the closed state). In some embodiments, regardless of the closed state or the opened state, a portion of the exposed second area A2 may be located on the guide member (not illustrated), and a portion of the second area A2 may maintain the curved shape at the position corresponding to the guide member (not illustrated). FIGS. 5 and 6 illustrate an embodiment in which the guide member is provided on the left edge of the electronic device 300, but the disclosure is not necessarily limited thereto. Unlike this, an embodiment in which the guide member is provided on the right edge (e.g., the first side wall 323a portion) of the electronic device 300 may also be applied.

According to various embodiments, the edge thickness of the first area A1 illustrate in FIGS. 5 and 6 may be different from that of the second area A2. The edge thickness of the second area A2 may be smaller than that of the first area A1. In terms of thickness, the first area A1 and the second area A2 may have asymmetrical shapes when the first area A1 and the second area A2 are viewed in cross sections thereof. For example, the edge of the first area A1 may have a first radius of curvature, and the edge of the second area A2 may have a second radius of curvature different from the first radius of curvature. These will be described in detail later with reference to the embodiments illustrated in the drawings in FIG. 10A and subsequent figures.

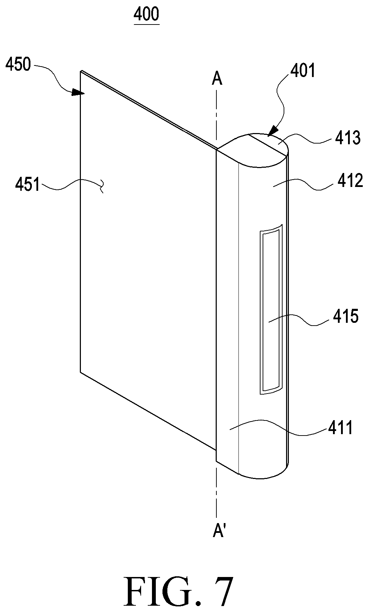

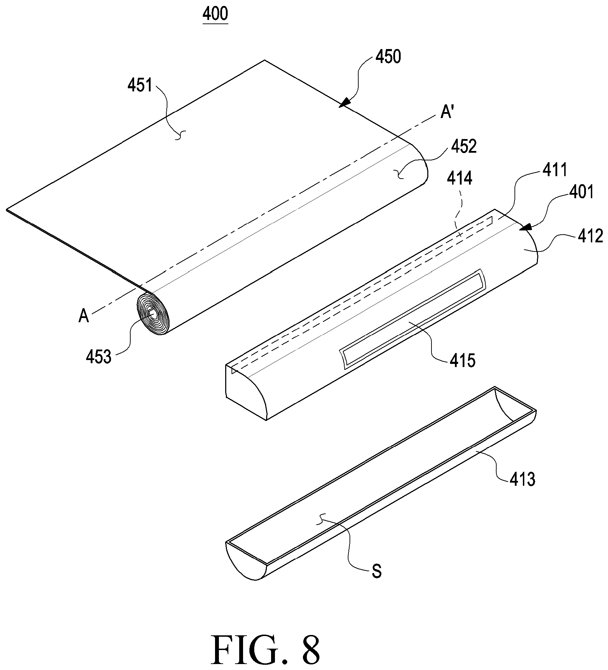

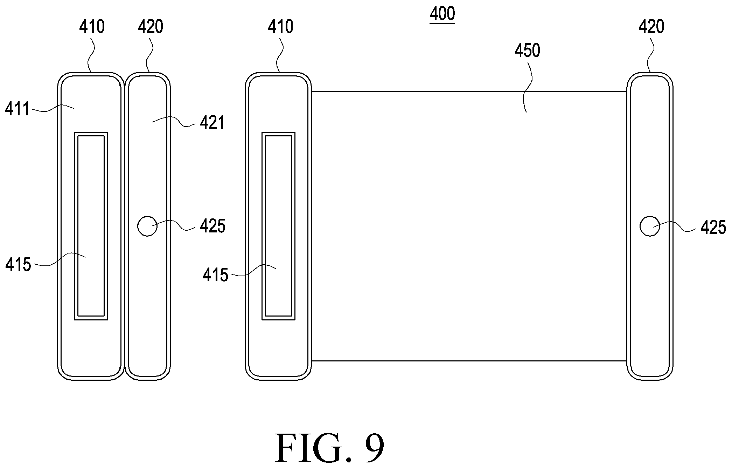

FIG. 7 is a perspective illustrating an electronic device 400 according to various embodiments disclosed herein. FIG. 8 is an exploded perspective illustrating an electronic device 400 according to various embodiments disclosed herein. FIG. 9 is a perspective view illustrating an electronic device 400 according to another embodiment disclosed herein.

The electronic device 400 of FIGS. 7 and 9 is another example of the electronic device 101 illustrated in FIG. 1 and may be a rollable electronic device.

The electronic device 400 according to various embodiments disclosed herein may include a housing 401 and a rollable display (hereinafter, referred to as a "display 450") at least partially accommodated (or received) in the housing 401.

The state illustrated in FIG. 7 may represent the state in which the display 450 is unrolled from the housing 401 of the electronic device 400. In FIG. 7, the extended state of the display 450 may include the state in which a portion of the display 450 is unrolled to the outside of the housing 401 and another portion is accommodated inside the housing 401. In addition, the state in which the display 450 is unrolled from the housing 401 may include the state in which at least a portion of the display 450 is rolled (or wound) and the rolled portion is at least partially accommodated in the housing 401.

According to various embodiments, the display 450 is accommodated inside the housing 401 by a slide-in operation or may be exposed outside the housing 401 by a slide-out operation. According to an embodiment, the entire display 450 may be accommodated inside the housing 401 in the state in which the display 450 is maximally accommodated inside the housing 401. Unlike this, according to another embodiment, in the state in which the display 450 is maximally accommodated inside the housing 401, at least a portion of the display 450 may be exposed outside the housing 401. For example, FIG. 7 may illustrate the state in which at least a portion of the display 450 (e.g., the first area 451) is exposed outside the housing 401 in the state in which the display 450 is maximally accommodated inside the housing 401.

Referring to FIG. 8, the housing 401 may accommodate various electrical and electronic components such as a main circuit board or a battery in an internal space S. For example, inside the housing 401, a processor (e.g., a central processor, a graphics processor, an image signal processor, or the like) configured to display a screen on the display 450 or a pressure sensor configured to detect a touch input or touch intensity may be accommodated. In addition, inside the housing 401, for example, components such as a camera module and sensor modules such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or a luminance sensor may be included.

According to an embodiment, the housing 401 may include a flat portion 411 oriented in the first direction. In addition, according to an embodiment, the housing 401 may include a curved portion 412 have a shape corresponding to the bent portion of the display. The curved portion 412 may have a shape in which one side extends from the flat portion 411 and the other side is bent from the flat portion 411 toward the rear surface of the housing 401 (e.g., the rear housing 413). The curved portion 412 may seamlessly extend from the flat portion 411.

The housing 401 may include a front housing including a flat portion 411 and a curved portion 412 and a rear housing 413 coupled to the front housing to define an inner space S. According to an embodiment, the front housing and the rear housing 413 may be integrated with each other. Alternatively, unlike this, the housing 401 may further include components (e.g., a bracket) other than the front housing and the rear housing 413.

In one surface of the housing 401, an opening 414 through which the display 450 is accommodated into or extracted out of the housing may be provided. Through the opening 414, at least one portion (e.g., a second area 452) of the display 450 may be accommodated into the inner space of the housing 401 by a sliding-in operation or at least another portion (e.g., a first area 451) of the display 450 may be extracted out of the housing 401 by a sliding-out operation.

The display 450 may be coupled to or disposed adjacent to a touch-sensitive circuit, a pressure sensor capable of measuring touch intensity (pressure), and/or a digitizer configured to detect a magnetic field-type stylus pen. Accordingly, when a user touches the surface of the area of the display 450 exposed outside the housing, a corresponding touch input may be received. On the other hand, since the portion of the display 450 accommodated inside the housing is blocked by the housing 401, it may be difficult for the portion to receive a user's touch input. To this end, the electronic device 400 may include an input device 415. The input device 415 may be provided in the form of, for example, a button or a key, and may be provided on the flat portion 411 and/or the curved portion 412 of the housing 401. FIGS. 7 and 8 illustrated an embodiment in which the input device 415 is provided on the curved portion 412, and FIG. 9 illustrates an embodiment in which the input device 415 is provided on the flat portion 411.

According to an embodiment, the input device 415 may have a shape elongated in a direction parallel to the length direction of the housing 401. A user may manipulate the sliding-in or sliding-out operation of the display of the electronic device 400 through a touch on the input device 415 or may make various user inputs such as turning-on/off of display screens, display screen switching, application channel switching, volume tuning, and channel tuning. In addition, according to various embodiments, through the input device 415, light may blink or light of various colors may be output, and status information of the electronic device 400 may be visually provided.

According to various embodiments, a plurality of input devices 415 may be provided in the housing 401. According to an embodiment, one input device 415 is provided in the housing 401 as illustrated in FIGS. 7 and 8, but according to another embodiment, although not illustrated in the drawings, the housing 401 may be provided with two or more input devices. In the case where a plurality of input devices are provided, the arrangement and shapes thereof are not limited to those illustrated in the drawings and may vary depending on embodiments.

The display 450 may include a first area 451 and a second area 452 which extends from the first area 451 and is at least partially bent. Here, the at least partially bent portion may refer to a portion of the second area 452 accommodated in the housing 401 in a rolled shape. According to an embodiment, the first area 451 may be exposed outside the housing 401, and the second area 452 may have a shape extending from the first area 451 and wound and bent around a guide member 453 (e.g., a roller).

According to various embodiments, the edge thickness of the first area 451 illustrate in FIG. 8 may be different from that of the second area 452. The edge thickness of the second area A52 may be smaller than that of the first area 451. In terms of thickness, the first area 451 and the second area 452 may have asymmetrical shapes when the first area 451 and the second area 452 are viewed in cross sections thereof. For example, the edge of the first area 451 may have a first radius of curvature, and the edge of the second area 452 may have a second radius of curvature different from the first radius of curvature. These will be described in detail later with reference to the embodiments illustrated in the drawings in FIG. 10A and subsequent figures.

Referring to FIG. 9, the housing 401 may include a first housing 410 and a second housing 420. According to an embodiment, one end of the display 450 may be fixed to the first housing 410 and the other end of the display 450 may be fixed to the second housing 420. The display 450 may be accommodated in a rolled state by a guide member (e.g., the guide member 453 in FIG. 8) disposed inside the first housing 410, and additionally or alternatively, the display 450 may be accommodated in the second housing 420 in the state of being rolled by a guide member (not illustrated) disposed in the second housing.

According to various embodiments, the input device 415 may be disposed on the flat portion 411 of the first housing 410, rather than on the curved portion. According to various embodiments, the second housing 420 may also have the same or similar structure as the first housing 410. For example, the second housing 420 may include a curved portion and/or a flat portion 421 and may include at least one input device 425 on the surface thereof. FIG. 9 illustrates an embodiment in which the size of the first housing 410 is larger than that of the second housing 420, and the second area (e.g., the second area 452 of FIG. 8) of the display 450 is accommodated in the first housing 410, but the disclosure is not necessarily limited thereto. The sizes and shapes of the first housing 410 and the second housing 420 and whether or not the display 450 is accommodated may be variously set depending on embodiments.

Referring to FIGS. 8 and 9 together, according to an embodiment, as the first housing 410 and the second housing 420 move away from each other, the first area 451, which is an area of the display 450 exposed outside the housing may be extended. According to an embodiment, when the first housing 410 and the second housing 420 move away from each other in the state in which the second area 452 is wound in the first housing 410, the display 450 may be extended in one way. In contrast, in the state in which the second area 452 of the display 450 is wound in each of the first housing 410 and the second housing 420, the first housing 410 and the second housing 420 move away from each other, it is also possible for the display 450 to be extended in two ways.

According to various embodiments disclosed herein, an electronic device 101, 200, 300, or 400 may include a flexible display 160, 250, 350, or 450, wherein the flexible display 160, 250, 350, or 450 may include an at least partially bendable display panel and a window member defining the exterior of the display.

According to various embodiments, the flexible display 160, 250, 350, or 450 may include other components such as a polarization layer that allows only light having a specific wavelength to pass from a screen displayed on the display panel or the amount of light incident to the display panel, a touch detecting circuit, a touch panel provided with a pressure sensor capable of measuring the intensity (pressure) of a touch, a magnetic shield member configured to block noise, and a protective member configured to absorb physical impact acting on the panel, but in the disclosure, the descriptions of these components will be omitted for convenience of description.

The display panel may include a display element layer including one or more pixels and a TFT layer connected to the display element layer. According to various embodiments, the display panel may correspond to a panel such as an LCD, an LED, or an AMOLED, and may display various images according to various operating states, application execution, and content of the electronic device 101, 200, 300, or 400. According to various embodiments, the display panel may be a component coupled to a touch panel or disposed adjacent to the top or rear surface of the touch panel. The electronic device 101, 200, 300, or 400 may detect an input on the display surface by using such a display panel. Here, the input can be recognized by the display panel include not only an input through direct contact but also an input through hovering.

According to various embodiments, at least a portion of the window member may be made of a substantially transparent material. For example, at least a portion of the window member 102 may be made of a glass plate or a polymer plate including various coating layers. According to an embodiment, the display panel may be visually exposed through a significant portion of the window member.

According to an embodiment, the window member may be implemented with foldable thin glass (FTG) that is foldable and very thin (e.g., about 100 µm or less). The window member may be fabricated correspond to the size and shape of the electronic device 101, 200, 300, or 400 or the flexible display 160, 250, 350, or 450, typically by using a laser cutting apparatus or a CNC machining apparatus.

As described above in the background art, according to some embodiments, in a foldable, slidable, or rollable electronic device, is an edge portion, when the edge portions of a window member does not undergo a separate machining process, there is a possibility that defects, such as fractures, due to bumping during handling or due to crack propagation during bending may occur due to cracks, etching marks, or the like present in the edge portions. When the edge portions of the window member are thinned to improve the bending performance of the window member, the impact resistance of the window member may be deteriorated.

Hereinafter, through the embodiments of FIGS. 10A to 14, it is intended to provide a window member having improved bending performance and high impact resistance.

FIG. 10A is a conceptual view illustrating deformation of a window member 260 in a foldable electronic device (e.g., the electronic device 200 in FIGS. 2 to 4) according to various embodiments of the disclosure. FIG. 10B is a conceptual view illustrating curvatures R₁ and R₂ of a first edge 264 and a second edge 265 of the window member 260 in the foldable electronic device (e.g., the electronic device 200 of FIGS. 2 to 4) according to the present invention.

According to the present invention, the window member 260 includes first portions 261 and 262 and a second portion 263 extending from the first portions 261 and 262. The first portions 261 and 262 may correspond to the first housing structure 210 and the second housing structure 220 in, for example, the foldable electronic device of FIG. 10A. The first portions 261 and 262 may have a generally flat shape. The second portion 263 corresponds to the hinge portion 230 in the foldable electronic device of FIG. 10A. The second portion 263 corresponds to a bendable portion of the display. In the embodiments of FIGS. 10A and 10B, the second portion 263 may be a portion extending from the first portions 261 and 262 disposed at opposite ends thereof, but is not necessarily limited thereto. According to other embodiments, in the case of the rollable electronic device described above with reference to FIGS. 7 to 9, the first portion 261 may be disposed only at one end of the second portion 263.

Referring to FIGS. 10A and 10B together, in the window member 260, the inner edge (e.g., the first edge 264) and the outer edge (e.g., the second edge 265) of the foldable area may exhibit different behavior when the electronic device is in the folded state. For example, when the electronic device is in the unfolded state (e.g., when the electronic device of FIG. 2 or 4 is in the unfolded state), the inner edge (e.g., the first edge 264) and the outer edge (e.g., the second edge 265) of the window member 260 may have the same length. When the electronic device is folded, the window member 260 is bent, and accordingly, deformation of the window member 260 may increase as the distance from the center of the radius of curvature to the outside increases. As illustrated in FIG. 10A, when the electronic device is in the folded state, the inner edge (e.g., the first edge 264) of the window member 260 may have a deformed length W₁, and the outer edge (e.g., the second edge 265) may have a deformed length W₂. The deformed length W₁ at the inner edge (e.g., the first edge 264) may be smaller than the deformed length W₂ at the outer edge (e.g., the second edge 265). This difference in length may be due to a difference in radius of curvature (R₂>R₁) between the inner edge (e.g., the first edge 264) and the outer edge (e.g., the second edge 265). As such, different tensile forces are generated on the inside and outside of the window member 260 depending on the radii of curvature. When an imbalance in tensile force occurs due to repeated use of the foldable electronic device, the window member 260 may be cracked.

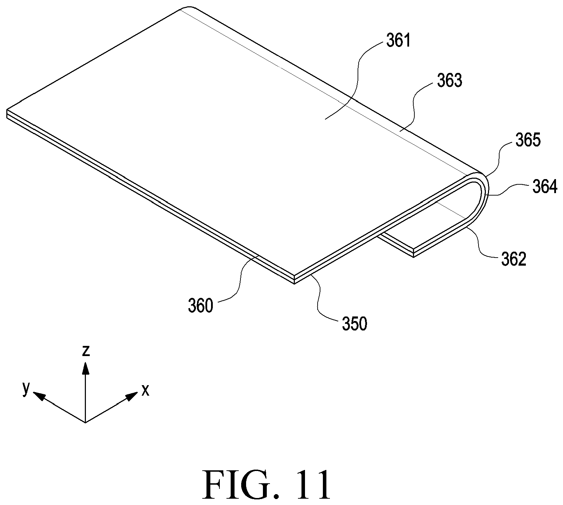

FIG. 11 illustrates a display 350 mounted on a slidable electronic device (e.g., the electronic device 300 in FIGS. 5 and 6) according to various embodiments of the disclosure and a window member 360 included in the display 350.

The window member 360 may include first portions 361 and 362 and a second portion 363 extending from the first portions 361 and 362. The first portions 361 and 362 may be, for example, portions that are seated on the first structure 310 in, for example, a slidable electronic device. However, it is not necessarily limited thereto, and one portion 362 of the first portions 361 and 362 may be seated on the second structure 320. Here, the first portions 361 and 362 may have a substantially flat shape. The second portion 263 may be, for example, a portion corresponding to a guide member (not illustrated) in a slidable electronic device. The second portion 263 may correspond to a bendable portion of the display 350. Although not illustrated in the drawings, in a slidable electronic device, multiple bars and/or plates may be disposed on the rear surface of the display 350 and may be configured to be movable while being supported by the multiple bars and/or plates. According to an embodiment, the window member 360 is also movable simultaneously with the movement of the display 350, and at this time, at least a portion of the second portion 362 may be deformed from a bent state to a state parallel to the first portions 361 and 362. In the embodiment of FIG. 11, the deformation of the window member 360 may increase as a distance from the center of the radius of curvature increases outward, similar to the embodiment illustrated in FIGS. 10A and 10B. Due to this characteristic, the window member 360 according to the embodiment of FIG. 11 may have problems similar to those of the window member 260 described above with reference to FIGS. 10A and 10B. Although not separately illustrated in the drawing, the display 450 of the rollable electronic device 400 according to the embodiment illustrated in FIGS. 7 to 9 may also include a window member (not illustrated), and the window member here may also have problems similar to those of the window members 260 and 360 according to the embodiments illustrated in FIGS. 10A to 11 in a portion corresponding to the second area 452, at a portion of which is bent. That is, different tensile forces are generated on the inside and outside of the window member 360 illustrated in FIG. 11 depending on the radii of curvature. When an imbalance in tensile force occurs due to repeated use of the foldable electronic device, the window member 260 may be cracked.

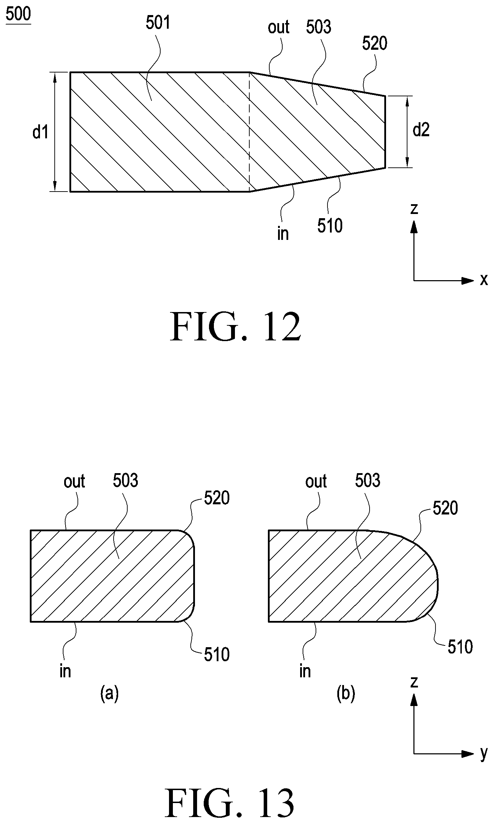

FIG. 12 is a cross-sectional view illustrating a window member 500 according to various embodiments of the disclosure. FIG. 13 is a cross-sectional view illustrating a second portion 503 of the window member 500 according to various embodiments of the disclosure.

According to the present invention, the window member 500 includes a first portion 501 (e.g., the first portions 361 and 362 in FIG. 11) having a first thickness d1, and a second portion 503 (e.g., the second portion 363 in FIG. 11) extending from the first portion 501 in a first direction (e.g., a direction parallel to the x axis) to at least partially have substantially the same thickness as the first portion 501. The second portion 503 includes an edge area extending in a second direction (e.g., a direction parallel to the y axis) perpendicular to the first direction and having a second thickness d2 smaller than the first thickness d1. According to various embodiments, the second portion 503 corresponds to a bendable portion of the display panel.

The window member 500 may include, as the edge area, a first edge 510 (e.g., the first edge 364 in FIG. 11) that is bent inward and a second edge 520 (e.g., the second edge 365 in FIG. 11) that is bent outward. FIG. 12 illustrates an inwardly bent portion (in) and an outwardly bent portion (out) based on the bending direction of the window member 500. Referring to FIG. 12, the first edge 510 and the second edge 520 are illustrated as having the same slope, but are not necessarily limited thereto.

Referring to FIG. 13, the first edge 510 and the second edge 520 may be asymmetrical to each other. For example, as illustrated in (a) of FIG. 13, the first edge 510 and the second edge 520 may have the same radius of curvature, but otherwise, as illustrated in (b) of FIG. 13, the first edge 510 and the second edge 520 may have different radii of curvature. The shape of the second portion 503 including the first edge 510 and the second edge 520 may vary. For example, the second portion may have a tapered shape, a rounded shape, or a shape in which a tapered shape and a round shape are implemented together. In addition, for example, an asymmetrical shape in which an inclined surface or a round shape is implemented on one side and an edge is not substantially implemented on the other side, or an asymmetrical shape in which the inclination angles of the edges are different from each other is also applicable. In addition, various embodiments for the edge shapes are applicable.

The edge areas (the first edge 510 and/or the second edge 520) according to various embodiments may be implemented in a process of polishing (or grinding) the ends of the window member 500. According to various embodiments of the disclosure, polishing the edge area (the first edge 510 and/or the second edge 520) are able to remove cracks and to have an effect of preventing glass fracture by handling during a process. In the edge polishing (or grinding) process, for example, the asymmetrical shapes of the edge areas (the first edge 510 and/or the second edge 520) may be implemented by using a difference in the polishing amounts of the edges depending on the contact time of a polishing brush (e.g., a wheel). As an example, through the edge polishing, the window member 500 may have a roughness of about 5 to 100 nm in a measurement length section (e.g., 1 to 10 mm). However, the edge areas (the first edge 510 and/or the second edge 520) are not limited to being implemented only by the above method. For example, the edge areas (the first edge 510 and/or the second edge 520) may be processed by etching with a chemical solution. The asymmetrical shapes of the edge areas (the first edge 510 and/or the second edge 520) may be implemented by using a difference in the etching amounts of the edges depending on the contact time of the etching solution (e.g., a hydrofluoric acid-based etching solution). As another example, the edge areas (the first edge 510 and/or the second edge 520) may be implemented by using laser processing. The asymmetric shapes of the edge areas (the first edge 510 and/or the second edge 520) may be implemented through laser differential processing. In addition, various shapes of the edge areas (the first edge 510 and/or the second edge 520) may be implemented by using various manufacturing methods.

According to various embodiments of the disclosure, the second edge 520 may have a greater inclination angle or radius of curvature than the first edge 510. For example, the second edge 520 is an outer portion when the window member is bent, and may have a greater amount of deformation than the inner first edge 510. Accordingly, when the second edge 520 has a greater inclination angle or radius of curvature than the first edge 510, the second edge 520 may be more resistant to damage.

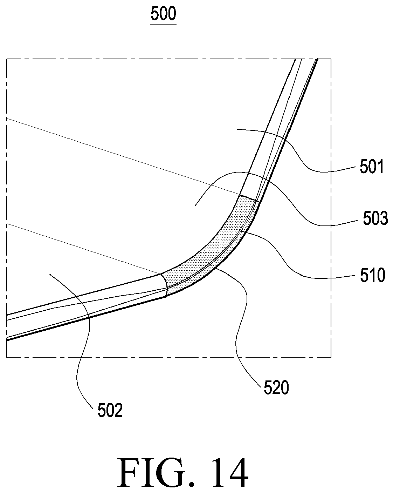

FIG. 14 is a perspective view illustrating a window member 500 mounted on a foldable electronic device according to various embodiments of the disclosure.

According to various embodiments, the second thickness (e.g., d2 in FIG. 12) of the edge area of the second portion 503 is gradually reduced as the distance from a portion adjacent to the first portion 501 or 502 increases. The thickness from the first portion 501 or 502 to the second portion 503 may continuously change from a large thickness to a small thickness, for example, like a gradation effect. For example, the first portion 501 may be formed to have a first thickness, the second portion 503 continuously formed following the first portion 501 may be formed to have a second thickness, and the third portion 502 continuously formed following the second 503 may be formed to have a first thickness.

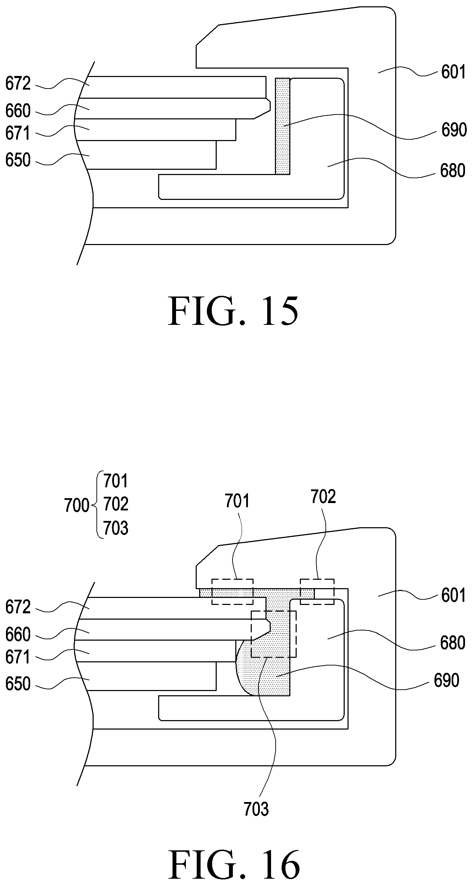

FIG. 15 is a cross-sectional view illustrating an impact resistance improving structure (e.g., an impact absorbing member 690) included in an electronic device according to various embodiments of the disclosure. FIG. 16 is a cross-sectional view illustrating a waterproof member 700 included in an electronic device according to various embodiments of the disclosure.

According to various embodiments, the electronic device 101, 200, 300, or 400 may include a display 650, a window member 660, a polarization layer 671, and a protection member 672.

According to various embodiments, the electronic devices 101, 200, 300, or 400 may further include an impact absorbing member 690 as an impact resistance improving structure to protect the window member 660 having a different thickness in the vicinity of a folding area. According to an embodiment, the impact absorbing member 690 may be mounted on a side surface member 680 separately provided inside the housing 601. Here, the side surface member 680 may be a separate component from or substantially the same component as the side surface bezel structure of the housing of the electronic device 101, 200, 300, or 400.

According to various embodiments, the electronic device 101, 200, 300, or 400 may further include a waterproof member 700 in order to waterproof the vicinity of the window member 660 having a different thickness in the vicinity of the folding area. The waterproof member 700 may include a portion made of an elastic material that is injected into and fills the gap between the top surface of the window member 660 and the housing 601.

According to an embodiment, the waterproof member 700 may include a first waterproof portion 701 between the housing 601 and the window member 660, a second waterproof portion 702 between the housing 601 and the side surface member 680, and a third waterproof portion 703 between the window member 660 and the side surface member 680. According to various embodiments, the electronic device 101, 200, 300, or 400 may include a light blocking member having a light blocking effect or low light transmittance in addition to or instead of the impact absorbing member 690 of FIG. 15 and the waterproof member 700 of FIG. 16 in order to block and/or reduce light leakage in the vicinity of the window member 600 having a different thickness in the vicinity of the folding area.

An electronic device according to various embodiments disclosed herein is an electronic device in which a display is expandable, wherein the electronic device may include a foldable electronic device in which at least a portion of the display is foldable around a folding area, a slidable electronic device in which at least a portion of the display is rectilinearly movable, and a rollable electronic device in which at least a portion of a display is rollable.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

In the foregoing detailed description of the disclosure, specific embodiments of the present disclosure have been described. However, it will be evident to a person ordinarily skilled in the art that various modification may be made without departing from the scope of the present disclosure.

## Claims

1. An electronic device (101, 200, 300, 400) comprising:
a housing (201, 301, 401); and
a flexible display (160, 250, 350, 450) comprising a display panel, at least a portion of which is bendable, and a window member (260, 360, 500, 660) comprising a transparent material and forming an exterior of the display,
wherein the window member comprises at most two first portions (261, 262, 361, 362, 501, 502) having a first thickness and a second portion (263, 363, 503) extending from the at least one first portion in a first direction,
wherein the second portion corresponds to the bendable portion of the display panel,
wherein at least a portion of the second portion has a thickness equal to the first thickness, wherein at least a portion of the second portion comprises an edge area,
wherein the edge area comprises a first edge (510) and a second edge (520), and extends in a second direction perpendicular to the first direction, and has a second thickness smaller than the first thickness, and
wherein the first edge (510) and the second edge (520) are asymmetrical to each other.

2. The electronic device of claim 1, wherein the first edge (264, 364, 510) which is bent inward and the second edge (265, 365, 520) which is bent outward.

3. The electronic device of claim 2, wherein the second edge (265, 365, 520) has a larger inclination angle or radius of curvature than the first edge (264, 364, 510).

4. The electronic device of claim 1, wherein the second thickness of the edge area of the second portion gradually decreases as moves away from the portion adjacent to the first portion.

5. The electronic device of claim 1, wherein the housing further comprises a side surface member (680) configured to protect a display, the side surface member being disposed to correspond to the second portion of the window member.

6. The electronic device of claim 1, wherein the housing further comprises an impact absorbing member (690) disposed to correspond to the second portion of the window member.

7. The electronic device of claim 1, wherein the housing further comprises a waterproof member (700) disposed to correspond to the second portion of the window member.

8. The electronic device of claim 7, wherein the waterproof member further comprises a portion filling a gap between a top surface of the window member and the housing.

9. The electronic device of claim 1, further comprising a hinge structure (230),
wherein the window member comprises two first portions (261, 262, 361, 362, 501, 502), and
wherein the housing comprises:
a first housing structure (210, 310) connected to the hinge structure and comprising a first surface and a second surface facing opposite to the first surface; and
a second housing structure (220, 320) connected to the hinge structure and comprising a third surface and a fourth surface facing opposite to the third surface, the second housing structure being folded with the first housing structure around the hinge structure.

10. The electronic device of claim 9, wherein the flexible display is visible from outside through at least one surface of the housing and extends from the first surface of the first housing structure to the third surface of the second housing structure.

11. The electronic device of claim 1, wherein the housing comprises a first surface (F1), a second surface (F2) facing away from the first surface (F1), a first side surface (323a) surrounding at least a portion of a space between the first surface and the second surface, and a second side surface (323b) facing away from the first side surface, and at least a portion of the housing is slid such that a distance between the first side surface and the second side surface is variable.

12. The electronic device of claim 11, wherein the flexible display comprises a first area visible from outside through at least one surface of the housing and a second area extending from the first area, and based on the sliding of the at least a portion of the housing, at least a portion of the second area is made to be visible from outside through at least one surface of the housing so that the first area can be extended.

13. The electronic device of claim 1, wherein the housing surrounds at least a portion of the flexible display, and
the housing is provided with an opening at one side thereof to allow the flexible display to be accommodated into or extracted out of the housing therethrough, and
the housing comprises, in an inner space thereof, a guide member (453) configured to guide the flexible display.

14. The electronic device of claim 13, wherein the flexible display comprises a first area, at least a portion of which is exposed outside the housing, and a second area extending from the first area and at least partially rolled around the guide member, wherein the first area is extendible when the second area is unrolled from the guide member.

## Patentansprüche

1. Elektronische Vorrichtung (101, 200, 300, 400), die Folgendes umfasst:
ein Gehäuse (201, 301, 401); und
ein flexibles Display (160, 250, 350, 450), das ein Anzeigefeld, von dem mindestens ein Teil biegsam ist, und ein Fensterelement (260, 360, 500, 660) umfasst, das ein transparentes Material umfasst und eine Außenseite des Displays bildet,
wobei das Fensterelement höchstens zwei erste Teile (261, 262, 361, 362, 501, 502) mit einer ersten Dicke und einen zweiten Teil (263, 363, 503) umfasst, der sich von dem mindestens einen ersten Teil in eine erste Richtung erstreckt,
wobei der zweite Teil dem biegsamen Teil des Anzeigefelds entspricht,
wobei mindestens ein Teil des zweiten Teils eine Dicke aufweist, die der ersten Dicke entspricht,
wobei mindestens ein Teil des zweiten Teils einen Randbereich umfasst,
wobei der Randbereich eine erste Kante (510) und eine zweite Kante (520) umfasst und sich in eine zweite Richtung senkrecht zu der ersten Richtung erstreckt und eine zweite Dicke aufweist, die kleiner als die erste Dicke ist, und
wobei die erste Kante (510) und die zweite Kante (520) asymmetrisch zueinander sind.

2. Elektronische Vorrichtung nach Anspruch 1, wobei die erste Kante (264, 364, 510) nach innen gebogen ist und die zweite Kante (265, 365, 520) nach außen gebogen ist.

3. Elektronische Vorrichtung nach Anspruch 2, wobei die zweite Kante (265, 365, 520) einen größeren Neigungswinkel oder Krümmungsradius als die erste Kante (264, 364, 510) aufweist.

4. Elektronische Vorrichtung nach Anspruch 1, wobei die zweite Dicke des Randbereichs des zweiten Teils allmählich abnimmt, je weiter er sich von dem an den ersten Teil angrenzenden Teil entfernt.

5. Elektronische Vorrichtung nach Anspruch 1, wobei das Gehäuse ferner ein Seitenflächenelement (680) umfasst, das so konfiguriert ist, dass es ein Display schützt, wobei das Seitenflächenelement so angeordnet ist, dass es dem zweiten Teil des Fensterelements entspricht.

6. Elektronische Vorrichtung nach Anspruch 1, wobei das Gehäuse ferner ein stoßdämpfendes Element (690) umfasst, das so angeordnet ist, dass es dem zweiten Teil des Fensterelements entspricht.

7. Elektronische Vorrichtung nach Anspruch 1, wobei das Gehäuse ferner ein wasserdichtes Element (700) umfasst, das so angeordnet ist, dass es dem zweiten Teil des Fensterelements entspricht.

8. Elektronische Vorrichtung nach Anspruch 7, wobei das wasserdichte Element ferner einen Teil umfasst, der einen Spalt zwischen einer Oberseite des Fensterelements und dem Gehäuse ausfüllt.

9. Elektronische Vorrichtung nach Anspruch 1, die ferner eine Scharnierstruktur (230) umfasst,
wobei das Fensterelement zwei erste Teile (261, 262, 361, 362, 501, 502) umfasst, und
wobei das Gehäuse Folgendes umfasst:
eine erste Gehäusestruktur (210, 310), die mit der Scharnierstruktur verbunden ist und eine erste Oberfläche und eine zweite Oberfläche umfasst, die entgegengesetzt zu der ersten Oberfläche ausgerichtet ist; und
eine zweite Gehäusestruktur (220, 320), die mit der Scharnierstruktur verbunden ist und eine dritte Oberfläche und eine vierte Oberfläche umfasst, die entgegengesetzt zu der dritten Oberfläche ausgerichtet ist, wobei die zweite Gehäusestruktur mit der ersten Gehäusestruktur um die Scharnierstruktur gefaltet ist.

10. Elektronische Vorrichtung nach Anspruch 9, wobei das flexible Display von außen durch mindestens eine Oberfläche des Gehäuses sichtbar ist und sich von der ersten Oberfläche der ersten Gehäusestruktur zu der dritten Oberfläche der zweiten Gehäusestruktur erstreckt.

11. Elektronische Vorrichtung nach Anspruch 1, wobei das Gehäuse eine erste Oberfläche (F1), eine zweite Oberfläche (F2), die von der ersten Oberfläche (F1) abgewandt ist, eine erste Seitenfläche (323a), die mindestens einen Teil eines Raums zwischen der ersten Oberfläche und der zweiten Oberfläche umgibt, und eine zweite Seitenfläche (323b) umfasst, die von der ersten Seitenfläche abgewandt ist, und mindestens ein Teil des Gehäuses so verschoben wird, dass ein Abstand zwischen der ersten Seitenfläche und der zweiten Seitenfläche variabel ist.

12. Elektronische Vorrichtung nach Anspruch 11, wobei das flexible Display einen ersten Bereich, der von außen durch mindestens eine Oberfläche des Gehäuses sichtbar ist, und einen zweiten Bereich umfasst, der sich von dem ersten Bereich erstreckt, und wobei basierend auf dem Verschieben des mindestens einen Teils des Gehäuses mindestens ein Teil des zweiten Bereichs von außen durch mindestens eine Oberfläche des Gehäuses sichtbar gemacht wird, sodass der erste Bereich erweitert werden kann.

13. Elektronische Vorrichtung nach Anspruch 1, wobei das Gehäuse mindestens einen Teil des flexiblen Displays umgibt, und
das Gehäuse auf einer Seite davon mit einer Öffnung versehen ist, durch die das flexible Display in das Gehäuse eingesetzt oder aus diesem entnommen werden kann, und
das Gehäuse in einem inneren Raum davon ein Führungselement (453) umfasst, das zum Führen des flexiblen Displays konfiguriert ist.

14. Elektronische Vorrichtung nach Anspruch 13, wobei das flexible Display einen ersten Bereich, von dem mindestens ein Teil außerhalb des Gehäuses freiliegt, und einen zweiten Bereich umfasst, der sich von dem ersten Bereich erstreckt und zumindest teilweise um das Führungselement gerollt ist, wobei der erste Bereich erweiterbar ist, wenn der zweite Bereich von dem Führungselement abgerollt wird.

## Revendications

1. Dispositif électronique (101, 200, 300, 400) comprenant :
un boîtier (201, 301, 401) ; et
un écran flexible (160, 250, 350, 450) comprenant un panneau d'affichage, dont au moins une portion est pliable, et un élément de fenêtre (260, 360, 500, 660) comprenant un matériau transparent et formant un extérieur de l'écran,
où l'élément de fenêtre comprend au plus deux premières portions (261, 262, 361, 362, 501, 502) ayant une première épaisseur et une deuxième portion (263, 363, 503) s'étendant de l'au moins une première portion dans une première direction,
où la deuxième portion correspond à la portion pliable du panneau d'affichage, où au moins une portion de la deuxième portion a une épaisseur égale à la première épaisseur,
où au moins une portion de la deuxième portion comprend une zone de bord, où la zone de bord comprend un premier bord (510) et un deuxième bord (520), et s'étend dans une deuxième direction perpendiculaire à la première direction, et a une deuxième épaisseur plus petite que la première épaisseur, et
où le premier bord (510) et le deuxième bord (520) sont asymétriques l'un par rapport à l'autre.

2. Dispositif électronique selon la revendication 1, où le premier bord (264, 364, 510) est plié vers l'intérieur et le deuxième bord (265, 365, 520) est plié vers l'extérieur.

3. Dispositif électronique selon la revendication 2, où le deuxième bord (265, 365, 520) a un angle d'inclinaison ou un rayon de courbure plus grand que le premier bord (264, 364, 510).

4. Dispositif électronique selon la revendication 1, où la deuxième épaisseur de la zone de bord de la deuxième portion décroît progressivement à mesure qu'elle s'éloigne de la portion adjacente à la première portion.

5. Dispositif électronique selon la revendication 1, où le boîtier comprend en outre un élément de surface latérale (680) configuré pour protéger un écran, l'élément de surface latérale étant disposé pour correspondre à la deuxième portion de l'élément de fenêtre.

6. Dispositif électronique selon la revendication 1, où le boîtier comprend en outre un élément d'absorption d'impacts (690) disposé pour correspondre à la deuxième portion de l'élément de fenêtre.

7. Dispositif électronique selon la revendication 1, où le boîtier comprend en outre un élément étanche à l'eau (700) disposé pour correspondre à la deuxième portion de l'élément de fenêtre.

8. Dispositif électronique selon la revendication 7, où l'élément étanche à l'eau comprend en outre une portion comblant un écart entre une surface supérieure de l'élément de fenêtre et le boîtier.

9. Dispositif électronique selon la revendication 1, comprenant en outre une structure de charnière (230),
où l'élément de fenêtre comprend deux premières portions (261, 262, 361, 362, 501, 502), et où le boîtier comprend :
une première structure de boîtier (210, 310) connectée à la structure de charnière et comprenant une première surface et une deuxième surface opposée à la première surface ; et
une deuxième structure de boîtier (220, 320) connectée à la structure de charnière et comprenant une troisième surface et une quatrième surface opposée à la troisième surface, la deuxième structure de boîtier étant repliée avec la première structure de boîtier autour de la structure de charnière.

10. Dispositif électronique selon la revendication 9, où l'écran flexible est visible de l'extérieur à travers au moins une surface du boîtier et s'étend de la première surface de la première structure de boîtier à la troisième surface de la deuxième structure de boîtier.

11. Dispositif électronique selon la revendication 1, où le boîtier comprend une première surface (F1), une deuxième surface (F2) dos à la première surface (F1), une première surface latérale (323a) entourant au moins une portion d'un espace entre la première surface et la deuxième surface, et une deuxième surface latérale (323b) dos à la première surface latérale, et au moins une portion du boîtier est coulissante de sorte qu'une distance entre la première surface latérale et la deuxième surface latérale est variable.

12. Dispositif électronique selon la revendication 11, où l'écran flexible comprend une première zone visible de l'extérieur à travers au moins une surface du boîtier et une deuxième zone s'étendant à partir de la première zone, et en fonction du coulissement de l'au moins une portion du boîtier, au moins une portion de la deuxième zone devient visible de l'extérieur à travers au moins une surface du boîtier de sorte que la première zone peut être étendue.

13. Dispositif électronique selon la revendication 1, où le boîtier entoure au moins une portion de l'écran flexible, et
le boîtier est pourvu d'une ouverture sur un côté de celui-ci pour permettre à l'écran flexible d'être logé dans ou extrait hors du boîtier à travers celle-ci, et
le boîtier comprend, dans un espace intérieur de celui-ci, un élément de guidage (453) configuré pour guider l'écran flexible.

14. Dispositif électronique selon la revendication 13, où l'écran flexible comprend une première zone, dont au moins une portion est exposée à l'extérieur du boîtier, et une deuxième zone s'étendant de la première zone et au moins partiellement enroulée autour de l'élément de guidage, où la première zone est extensible lorsque la deuxième zone est déroulée de l'élément de guidage.
